Europäisches Patentamt

European Patent Office

Office européen des brevets

(11) Numéro de publication: **0 138 706**
**B1**

(12) **FASCICULE DE BREVET EUROPEEN**

(45) Date de publication du fascicule du brevet:
08.11.89

(51) Int. Cl.⁴: **H 03 K 19/007**

(21) Numéro de dépôt: **84402029.7**

(22) Date de dépôt: **09.10.84**

(54) Circuit logique à seuil et à sécurité intrinsèque.

(30) Priorité: **13.10.83 FR 8316331**

(43) Date de publication de la demande:
**24.04.85 Bulletin 85/17**

(45) Mention de la délivrance du brevet:
**08.11.89 Bulletin 89/45**

(84) Etats contractants désignés:
**BE CH DE FR GB IT LI LU NL**

(56) Documents cités:
**DE-A- 1 413 959**
**FR-A- 2 510 845**
**US-A- 3 430 066**
**US-A- 3 584 236**

(73) Titulaire: **JEUMONT-SCHNEIDER Société anonyme dite:,
31-32, Quai de Dion Bouton, F-92811 Puteaux Cedex
(FR)**

(72) Inventeur: **Guillaumin, Jacques, 19-21, rue Henri
Barbusse, F-93260 Les Lilas (FR)**

(74) Mandataire: **Weinmiller, Jürgen et al,
Lennéstrasse 9 Postfach 24, D-8133 Feldafing (DE)**

ACTORUM AG

## Description

La présente invention concerne des circuits logiques à seuil et à sécurité intrinsèque tels que de toute modification des caractéristiques de l'un de ses composants résulte une augmentation relative de la valeur du seuil et comprenant un comparateur à l'une des entrées duquel est appliquée une tension continue de référence tandis que l'autre entrée est connectées au point de jonction d'une première et d'une deuxième résistances, une première tension continue négative de valeur relative basse résultant de la transformation d'un signal alternatif appliqué à une entrée par une première pompe à diodes étant appliquée à l'autre extrémité de ladite première résistance, et une deuxième tension continue de valeur relative élevée étant appliquée à l'autre extrémité de ladite deuxième résistance par l'intermédiaire d'une troisième résistance, une troisième tension continue de valeur relative intermédiaire étant appliquée au point de jonction desdites deuxième et troisième résistances par l'intermédiaire d'une quatrième résistance en série avec un commutateur de hachage.

On connaît par le document FR-A-2 510 845 un circuit logique à seuil et à sécurité intrinsèque, possédant au moins une entrée et une sortie et tel que d'aucune panne ou modification des caractéristiques du circuit ne peut résulter un signal de sortie si le seuil n'est pas atteint.

On connaît aussi par le document US-A-3 584 236 un circuit logique à seuil et à sécurité intrinsèque, comportant un comparateur constitué par un transistor monté en base commune, dont la base est reliée à une tension continue de référence (tension de polarisation apparaissant à la jonction), tandis que l'émetteur est connecté au point de jonction d'une première et d'une seconde résistance, et dont le signal de sortie est prélevé sur le collecteur, une première tension continue de valeur relative basse étant appliquée à l'autre extrémité de la première résistance. La tension apparaissant à l'autre extrémité de la seconde résistance est une tension alternative ou en créneaux.

Un but de l'invention est de procurer des circuits logiques de ce genre constituant pour plusieurs signaux alternatifs, soit une port «OU», soit une porte «ET».

Le circuit logique constituant une porte «OU» pour plusieurs signaux alternatifs est caractérisé en ce qu'une autre pompe à diodes est connectée en parallèle avec la première pompe à diodes.

Le circuit logique constituant une porte «ET» pour plusieurs signaux alternatifs est caractérisé en ce qu'une autre pompe à diodes est connectée en série avec la première pompe à diodes, en augmentant en conséquence la valeur de seuil du circuit.

Pour l'un et l'autre de ces circuits logiques, le collecteur du transistor est de préférence relié à un amplificateur de courant, ce dernier étant avantageusement constitué par deux transistors montés en collecteur commun et de types complémentaires, dont la réunion des bases en constitue l'entrée et celle des émetteurs la sortie tandis qu'à leurs collecteurs sont respectivement appliquées les deuxième et troisième tensions continues.

La présente invention sera mieux comprise et d'autres buts, avantages et caractéristiques de celle-ci apparaîtront plus clairement à la lecture qui va suivre des modes de réalisation de l'invention en porte «OU» et en porte «ET», en référence aux figures du dessin annexé.

La figure 1a est le schéma électronique d'un circuit logique connu de base.

La figure 1b est un diagramme de temps de certains signaux apparaissant dans le circuit, servant à expliciter son fonctionnement.

La figure 2 est le schéma électronique du circuit logique représenté figure 1a où un transistor monté en base commune a été substitué au comparateur.

La figure 3 est le schéma électronique d'un circuit logique «OU» selon l'invention pour deux signaux alternatifs.

La figure 4 est un schéma électronique d'un circuit logique «ET» selon l'invention pour deux signaux alternatifs.

En référence maintenant à la figure 1a, la tension continue de valeur relative basse est chosie négative (V1), celle de valeur relative élevée est choisie positive (V2) et celle de valeur intermédiaire est choisie nulle (V3).

Le commutateur 6 est relié d'une part directement à la masse (V3) et d'autre part par l'intermédiaire des deux résistances 3 et 4 à la tension V2. Le commutateur hache le courant dans ces deux résistances et crée au point de jonction A de ces deux résistances 3 et 4 un signal en forme de créneau de tensions extrêmes V2 et KV2, K étant fonction des valeurs des résistances 3 et 4 et inférieur à 1.

Si le commutateur 6 reste ouvert, la tension VA croît et aucun signal en forme de créneau n'est transmis au comparateur 7 qui délivre alors en sortie un signal continu. Il en est de même si la résistance 4 est coupée. Si la résistance 3 est coupée, la tension VA chute et le signal en forme de créneau ne présente plus une amplitude suffisante pour faire commuter le comparateur 7. Si la résistance 2 est coupée, bien évidemment aucun signal n'est transmis au comparateur 7.

On constate donc que ce circuit présente bien la sécurité intrinsèque requise notamment parce que le signal utile appliqué au comparateur 7 doit être la somme d'un signal en forme de créneau et d'une tension continue et doit présenter une amplitude déterminée comprise entre deux bornes pour que le comparateur 7 puisse assurer sa fonction.

Un comparateur 7 est disposé de manière qu'à l'une de ses entrées soit appliquée une tension de référence VR tandis que son autre entrée est reliée au point de jonction B de deux résistances 1 et 2. A l'autre extrémité E de la résistance 1 est appliquée la tension négative V1 tandis que l'autre extrémité de la résistance 2 est reliée au point A précité. Le comparateur 7 comporte une sortie S qui constitue la sortie du circuit logique.

Ce signal en forme de créneau est alors transmis du point A au point B par la résistance 2. La tension négative V1 appliquée au point E est transmise au point B par la résistance 1. Il apparaît donc au point B un signal créneau de tension extrêmes U et V, U et V étant fonction des tensions V1, V2 et des résistances 1, 2, 3 et 4.

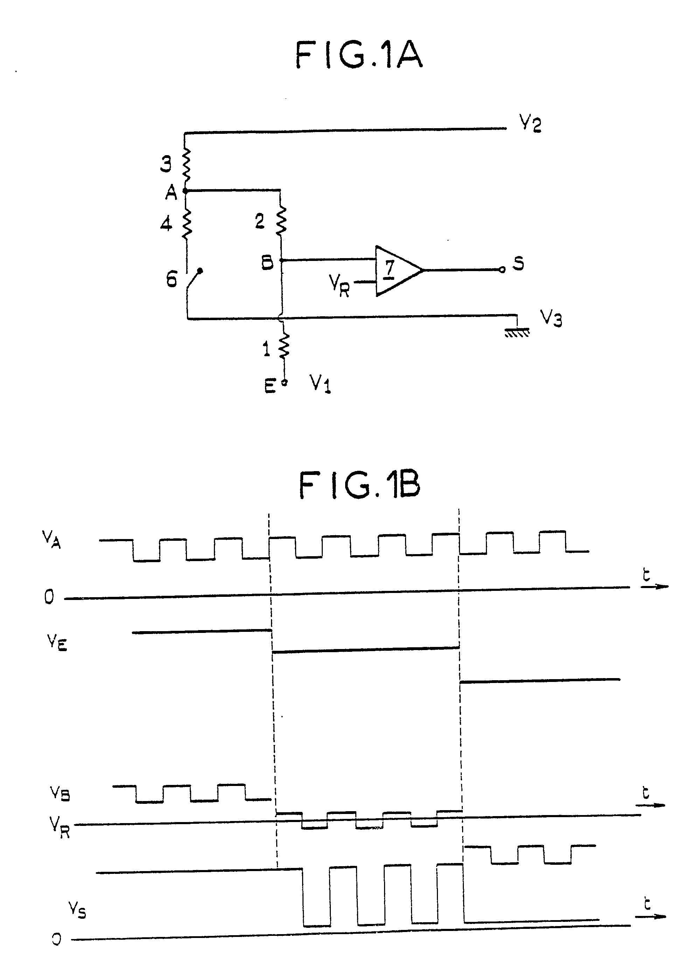

A la figure 1b sont représentées en fonction du temps et de la tension appliquée au point E les tensions aux points A et B, et en sortie, de manière à expliciter le fonctionnement du dispositif.

On constate sur la partie gauche de ce diagramme, que si la tension appliquée en E n'est pas suffisamment négative, la tension au point B n'approche pas suffisamment la tension de référence VR pour permettre au commutateur 6 de commuter comme dans la partie centrale de cette figure où l'on voit que la tension de sortie VS n'affecte la forme de créneau que si la tension VB coupe la tension de référence VR. De même, à droite de la figure, on voit que si la tension VE est trop négative, le commutateur 6 ne commute plus.

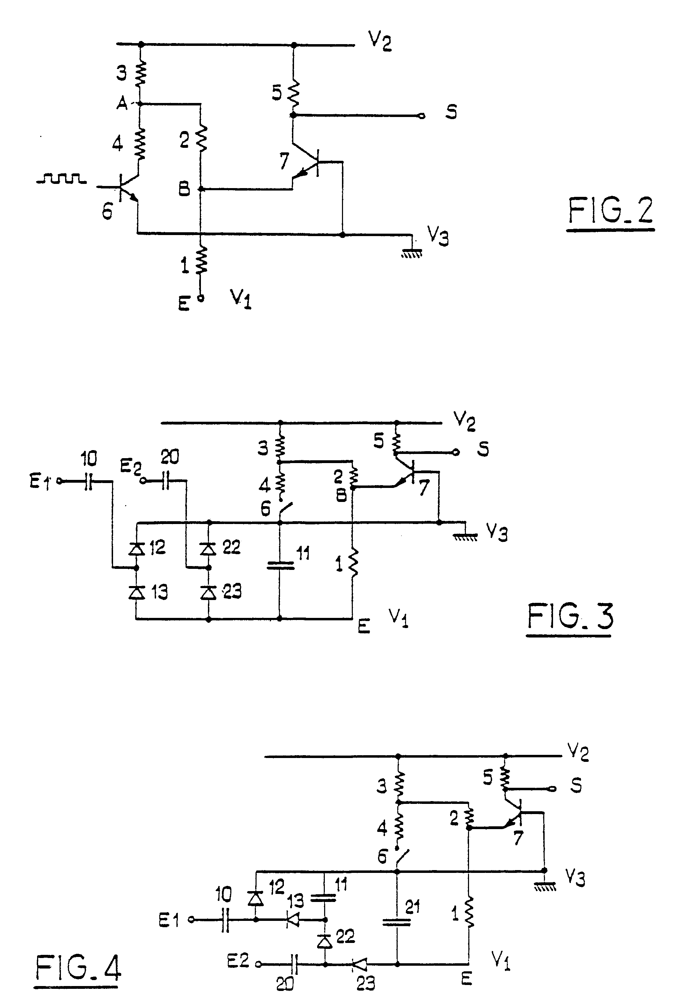

En référence à la figure 2, le comparateur a été réalisé à l'aide d'un transistor 7 monté en base commune, et le commutateur 6 réalisé au moyen d'un transistor représenté schématiquement, par exemple piloté par une horloge.

La tension bas-émetteur du transistor 7 correspond à la tension de référence VR appliquée à une entrée du comparateur de la figure 1a.

Le point B est relié à l'émetteur du transistor 7. Le signal de sortie est prélevé au point S sur le collecteur de ce transistor, relié à la tension V2 par l'intermédiaire de la résistance 5.

On constate aisément que le transistor 7 contribue à la sécurité intrinsèque du circuit. En effet, de toute fuite entre ses collecteur et émetteur résulte une augmentation de la tension au point B entraînant une absence de signal en sortie du circuit. Il en est de même, mais avec un effet moindre, en cas de fuite bas-émetteur. Enfin une fuite collecteur-base entraîne une diminution de l'amplitude du signal de sortie et par suite l'absence de créneaux dans ce signal.

En référence à la figure 3, un circuit logique «OU» pour deux signaux alternatifs est obtenu à partir du circuit logique représenté à la figure 1a en branchant deux pompes à diodes en parallèle sur l'entrée du circuit.

La première pompe à diodes est constituée des condensateurs 10 et 11 et des diodes 12 et 13, la deuxième pompe à diodes étant constituée des condensateurs 20 et 11 et des diodes 22 et 23, le condensateur 11 est commun aux deux pompes à diodes.

Chaque pompe à diodes transforme le signal alternatif appliqué à une entrée du circuit (E1, E2) en une tension négative. La tension V1, appliquée au point E correspond à la plus grande de ces deux tensions négatives, comparées en valeur absolue. La tension de seuil du circuit correspond à celle choisie par un circuit ne comportant qu'une seule pompe à diodes.

Il suffit qu'un signal alternatif soit appliqué à une des entrées E1, E2 du circuit pour que la tension au point B permette qu'un signal apparaisse au point S, sortie du circuit.

En référence à la figure 4, un circuit logique «ET» pour deux signaux alternatifs est obtenu à partir du circuit logique représenté à la figure 1a en branchant deux pompes à diodes en série sur l'entrée du circuit.

La première pompe à diodes est constituée de deux condensateurs 10 et 11 et de deux diodes 12 et 13. La deuxième est constituée de deux condensateurs 20 et 21 et de deux diodes 22 et 23.

Chaque pompe à diodes transforme le signal alternatif appliqué à une entrée du circuit (E1, E2) en une tension négative E. La tension V1, appliquée au point E est la somme de ces deux tensions. Pour assurer un bon fonctionnement du dispositif, la tension de seuil du circuit est augmentée en conséquence en modifiant le rapport des valeurs des résistances 1 et 2.

Il faut qu'un signal alternatif soit appliqué à chaque entrée E1, E2 du circuit pour que la tension au point B permette qu'un signal apparaisse au point S, sortie du circuit.

Bien que seuls certains modes de réalisation aient été décrits, il est évident que toute modification apportée par l'homme de l'art dans le même esprit ne sortirait pas du cadre de la présente invention. Par exemple, on peut modifier la plage de fonctionnement du circuit en ajoutant en série avec la résistance 1, une résistance active, un transistor à effet de champs par exemple commandé directement par le signal de sortie du circuit de manière à réaliser une auto-régulation.

## Revendications

1. Circuit logique à seuil et à sécurité intrinsèque tel que de toute modification des caractéristiques de l'un de ses composants résulte une augmentation relative de la valeur du seuil et comprenant un comparateur constitué par un transistor (7) monté en base commune, dont la base est reliée à une tension continue de référene (VR), tandis que l'émetteur est connecté au point de jonction d'une première et d'une deuxième résistances (1, 2), et dont le signal de sortie est prélevé sur le collecteur, une première tension continue négative (V1) de valeur relative basse, résultant de la transformation d'un signal alternatif appliqué à une entrée (E1) par une première pompe à diodes (10, 11, 12, 13), étant appliquée à l'autre extrémité de ladite première résistance (1), et une deuxième tension continue (V2) de valeur relative élevée étant appliquée à l'autre extrémité de ladite deuxième résistance (2) par l'intermédiaire d'une troisième résistance (3), une troisième tension continue (V3) de valeur relative intermédiaire étant appliquée au point de jonction (A) desdites deuxième et troisième résistances (2, 3) par l'intermédiaire d'une quatrième résistance (4) en série avec un commutateur (6) de hachage, caractérisé en ce qu'une autre pompe à diodes (20, 11, 22, 23) est connectée en parallèle avec ladite première pompe (10, 11, 12, 13), le circuit logique constituant alors une porte «OU» pour plusieurs signaux alternatifs.

2. Circuit logique à seuil et à sécurité intrinsèque tel que de toute modification des caractéristiques de l'un de ses composants résulte une augmentation relative de la valeur du seuil et comprenant un comparateur constitué par un transistor (7) monté en base commune, dont la base est reliée à une tension continue de référence (VR), tandis que l'émetteur est connecté au point de jonction d'une première et d'une deuxième résistances (1, 2), et dont le signal de sortie est prélevé sur le collecteur, une première tension continue négative (V1) de valeur relative basse, résultant de la transformation d'un signal alternatif appliqué à une entrée (E1) par une première pompe à diodes (10, 11, 12, 13) étant appliquée à l'autre extrémité de ladite première résistance (1), et une deuxième tension continue (V2) de valeur relative élevée étant appliquée à l'autre extrémité de ladite deuxième résistance (2) par l'intermédiaire d'une troisième résistance (3), une troisième tension continue (V3) de valeur relative intermédiaire étant appliquée au point de jonction (A) desdites deuxième et troisième résistances (2, 3) par l'intermédiaire d'une quatrième résistance (4) en série avec un commutateur (6) de hachage, caractérisé en ce qu'une autre pompe à diodes (20, 21, 22, 23) est connectée en série avec ladite première pompe (10, 11, 12, 13), ledit circuit logique constituant alors une porte «ET» pour plusieurs signaux alternatifs en augmentant en conséquence la valeur de seuil du circuit.

3. Circuit logique selon les revendications 1 ou 2, caractérisé en ce que le collecteur dudit transistor (7) est relié à l'entrée d'un amplificateur de courant.

4. Circuit logique selon la revendication 3, caractérisé en ce que ledit amplificateur de courant est constitué de deux transistors (31, 32) montés en collecteur commun et de types complémentaires dont la réunion des bases constitue l'entrée dudit amplificateur et celle des émetteurs la sortie tandis qu'à leurs collecteurs sont respectivement appliquées lesdites deuxième et troisème tensions continues (V2, V3).

5. Circuit logique selon l'une quelconque des revendications 1 à 4, caractérisé en ce qu'on dispose, en série avec ladite première résistance (1), un transistor à effet de champs commandé par le signal de sortie dudit comparateur (7).

**Claims**

1. An intrinsically safe logic threshold circuit of a design such that any modification of the characteristics of one of its components results in a relative increase of the threshold value, with the circuit comprising a comparator constituted by a transistor (7) mounted in common base arrangement, whose base is connected to a dc reference voltage (VR), whereas the emitter is connected to the junction point of a first and a second resistor (1, 2), and whose output signal is derived from the collector, a first negative dc volgage (V1) having a low relative value and resulting from the transformation of an alternating signal applied to an input (E1) via a first diode pump (10, 11, 12, 13) being applied to the other end of said first resistor (1), and a second dc voltage (V2) having an elevated relative value being applied to the other end of said second resistor (2) via a third resistor (3), a third dc voltage (V3) having an intermediate relative value being applied to the junction point (A) of said second and third resistors (2, 3) via a fourth resistor (4) connected in series with a chopper switch (6), characterized in that a further diode pump (20, 11, 22, 23) is connected in parallel to the first diode pump (10, 11, 12, 13), the logic circuit thus constituting an OR-gate for several alternating signals.

2. An intrinsically safe logic threshold circuit of a design such that any modification of the characteristics of one of its components results in a relative increase of the threshold value, with the circuit comprising a comparator constituted by a transistor (7) mounted in common base arrangement, whose base is connected to a dc reference voltage (VR), whereas the emitter is connected to the junction point of a first and a second resistor (1, 2), and whose output signal is derived from the collector, a first negative dc voltage (V1) having a low relative value and resulting from the transformation of an alternating signal applied to an input (E1) via a first diode pump (10, 11, 12, 13) being applied to the other end of said first resistor (1), and a second dc voltage (V2) having an elevated relative value being applied to the other end of said second resistor (2) via a third resistor (3), a third dc voltage (V3) having an intermediate relative value being applied to the junction point (A) of said second and third resistors (2, 3) via a fourth resistor (4) connected in series with a chopper switch (6), characterized in that a further diode pump (20, 21, 22, 23) is connected in series with the first diode pump (10, 11, 12, 13), said logic circuit thereby constituting an AND-gate for several alternating signals, with consequently increasing the threshold value of the circuit.

3. A logic circuit according to claim 1 or 2, characterized in that the collector of the transistor (7) is connected to the input of a current amplifier.

4. A logic circuit according to claim 3, characterized in that said current amplifier is constituted of two transistors (31, 32) mounted in a common collector arrangement and belonging to the complementary types, the connection of the base electrodes constituting the input of the amplifier and the connection of the emitter electrodes constituting the output, whereas their collectors are connected respectively to the second and third dc voltages (V2, V3).

5. A logic circuit according to any one of claims 1 to 4, characterized in that a field effect transistor controlled by the output signal of said comparator (7) is connected in series with said first resistor (1).

**Patentansprüche**

1. Eigensichere logische Schwellenschaltung von solcher Art, daß jegliche Änderung der Eigenschaften eines ihrer Bauteile zu einer relativen Erhöhung des Schwellwerts führt, wobei die Schaltung einen Komparator aufweist, bestehend aus einem Transistor (7) in Basisschaltung, dessen Basis an eine Bezugsgleichspannung (VR) angeschlossen ist, während der Emitter an den Verbindungspunkt zwischen einem ersten und einem zweiten Widerstand (1, 2) angeschlossen ist, und dessen Ausgangssignal am Kollektor abgenommen wird, wobei eine erste negative Gleichspannung (V1) eines geringen Relativwerts, die sich aus der Umwandlung eines an einen Eingang (E1) durch eine erste Diodenpumpe (10, 11, 12, 13) angelegten Wechselsignals ergibt, an das andere Ende des ersten Widerstands (1) angelegt ist, und eine zweite Gleichspannung (V2) hohen Relativwerts über einen dritten Widerstand (3) an das andere Ende des zweiten Widerstands (2) angelegt ist und wobei eine dritte Gleichspannung (V3) eines mittleren Relativwerts über einen vierten Widerstand (4) in Reihe mit einem Zerhacker (6) an den Verbindungspunkt (A) zwischen dem zweiten und dem dritten Widerstand (2, 3) angelegt ist, dadurch gekennzeichnet, daß eine weitere Diodenpumpe (20, 11, 22, 23) parallel zur ersten Pumpe (10, 11, 12, 13) angeschlossen ist, wodurch die logische Schaltung zu einem ODER-Tor für mehrere Wechselsignale wird.

2. Eigensichere logische Schwellenschaltung von solcher Art, daß jegliche Änderung der Eigenschaften eines ihrer Bauteile zu einer relativen Erhöhung des Schwellwerts führt, wobei die Schaltung einen Komparator aufweist, bestehend aus einem Transistor (7) in Basisschaltung, dessen Basis an eine Bezugsgleichspannung (VR) angeschlossen ist, während der Emitter an den Verbindungspunkt zwischen einem ersten und einem zweiten Widerstand (1, 2) angeschlossen ist, und dessen Ausgangssignal am Kollektor abgenommen wird, wobei eine erste negative Gleichspannung (V1) eines geringen Relativwerts, die sich aus der Umwandlung eines an einen Eingang (E1) durch eine erste Diodenpumpe (10, 11, 12, 13) angelegten Wechselsignals ergibt, an das andere Ende des ersten Widerstands (1) angelegt ist, und eine zweite Gleichspannung (V2) hohen Relativwerts über einen dritten Widerstand (3) an das andere Ende des zweiten Widerstands (2) angelegt ist und wobei eine dritte Gleichspannung (V3) eines mittleren Relativwerts über einen vierten Widerstand (4) in Reihe mit einem Zerhacker (6) an den Verbindungspunkt (A) zwischen dem zweiten und dem dritten Widerstand (2, 3) angelegt ist, dadurch gekennzeichnet, daß eine weitere Diodenpumpe (20, 21, 22, 23) in Reihe mit der ersten Pumpe (10, 11, 12, 13) geschaltet ist, wodurch die logische Schaltung zu einem UND-Tor für mehrere Wechselsignale unter folglicher Erhöhung des Schwellwerts der Schaltung wird.

3. Logikschaltung nach den Ansprüchen 1 oder 2, dadurch gekennzeichnet, daß der Kollektor des Transistors (7) an den Eingang eines Stromverstärkers angeschlossen ist.

4. Logikschaltung nach Anspruch 3, dadurch gekennzeichnet, daß der Stromverstärker aus zwei komplementären Transistoren (31, 32) in Kollektorbasisschaltung besteht, deren Zusammenschaltung der Basiselektroden den Eingang des Verstärkers und deren Zusammenschaltung der Emitterelektroden den Ausgang bildet, während an ihre Kollektoren die zweite bzw. die dritte Gleichspannung (V2, V3) angelegt ist.

5. Logikschaltung nach einem der beliebigen der Ansprüche 1 bis 4, dadurch gekennzeichnet, daß in Reihe mit dem ersten Widerstand (1) ein Feldeffekttransistor angeordent ist, der vom Ausgangssignal des Komparators (7) gesteuert wird.

# FIG.1A

# FIG.1B

EP 0 138 706 B1

FIG.2

FIG.3

FIG.4